# EUROPEAN PATENT APPLICATION

(11) **EP 1 768 132 A1**
(43) Date of publication of application: **28.03.2007**
(21) Application number: 05760135.3
(22) Date of filing: 14.07.2005
(51) Int. Cl.: H01B 5/00, H01B 1/22, H01B 13/00, B22F 1/02, C23C 18/31, C23C 18/44, H01R 11/01

(54) **CONDUCTIVE MICROPARTICLE, PROCESS FOR PRODUCING THE SAME AND ANISOTROPIC CONDUCTIVE MATERIAL**

(30) Priority: 15.07.2004 JP 2004208914
(71) Applicant: SEKISUI CHEMICAL CO., LTD., Osaka-shi, Osaka 530-8565 (JP)
(72) Inventor: KUBOTA, Takashi c/o Sekisui Chemical Co., Ltd., Koka-shi, Shiga 5288585 (JP)
(74) Representative: Hart Davis, Jason
(86) International application number: PCT/JP2005/013090
(87) International publication number: WO 2006/006687

(57) **Abstract**

The present invention aims to provide electroconductive fine particles having excellent electrical conductivity with fewer pinholes in a gold coating, a method of producing the electroconductive fine particles, which are cyan-free type with a plating bath excellent in stability, and an anisotropic electroconductive material using the electroconductive fine particles.

The present invention is an electroconductive fine particle, which has a gold coating formed by electroless gold plating on the surface of a nickel undercoating, the amount of nickel dissolved in a dissolution test of the electroconductive fine particle with nitric acid being 30 to 100 µg/g; a method of producing the electroconductive fine particle, wherein the method allows a reducing agent, causing oxidation reaction on the surface of a nickel undercoating but not causing oxidation reaction on the surface of gold as deposited metal, to be present on the surface of the nickel undercoating thereby reduces a gold salt to deposit gold; and an anisotropic electroconductive material, which comprises the electroconductive fine particle dispersed in a resin binder.

## Description

### TECHNICAL FIELD

The present invention relates to an electroconductive fine particle, a method of producing electroconductive fine particle, and an anisotropic electroconductive material, and in particular, to an electroconductive fine particle having excellent electrical conductivity with fewer pinholes in a gold coating, a method of producing the electroconductive fine particle, and an anisotropic electroconductive material using the electroconductive fine particle.

### BACKGROUND ART

Conventionally, metal particles such as gold, silver and nickel have been used as electroconductive fine particles, but they are often not uniformly dispersed in a binder resin because of their high specific gravity and uneven shape, to cause uneven electrical conductivity in an anisotropic electroconductive material.
To cope with this problem, electroconductive fine particles having a metallic coating such as nickel or nickel-gold formed by electroless plating on the surfaces of non-electroconductive particles such as resin particles or glass beads as core particles have been reported (see, for example, Patent Document No. 1).
Patent Document No. 1 discloses electroconductive electroless plating powder having a metallic coating formed by electroless plating on substantially spherical resin powder particles.

On the other hand, when electroconductive fine particles having a nickel coating are subjected to gold plating, substitution-type electroless gold plating has been conducted in the past.
However, the substitution-type electroless gold plating is a deposition method utilizing a difference in ionization tendency between undercoating nickel and gold, and its plating bath composition is relatively simple and easily controlled, but there is a problem that because the reaction is terminated once undercoating nickel is coated with gold, the thickness of the deposited coating is thin with many pinholes attributable to dissolution of the undercoating.

Accordingly, a high-speed substitution-type electroless gold plating solution wherein a thick coating can be formed regardless of substitution-type electroless gold plating (see, for example, Patent Document No. 2) and an electroless gold plating solution wherein substitution and reduction occur simultaneously (see, for example, Patent Document No. 3) have been reported.
However, the method of using these plating solutions is very sensitive to contaminants such as nickel, thus suffering from a problem that the plating bath is lacking in stability.

In gold plating, a cyan bath using gold cyanide or the like is usually employed because this plating bath is excellent in stability, but the cyan bath is used in a strongly alkaline state, and thus has a problem of strong corrosion of core particles etc. and a problem of being harmful to the environment, so there has been demand for cyan-free type electroless gold plating.
Patent Document No. 1: Japanese Kokai Publication Hei-8-311655
Patent Document No. 2: Japanese Kokai Publication Hei-5-295558
Patent Document No. 3: Japanese Kokai Publication Hei-4-371583

### DISCLOSURE OF THE INVENTION

### PROBLEMS WHICH THE INVENTION IS TO SOLVE

In view of the above-mentioned state of the art, the present invention aims to provide electroconductive fine particles having excellent electrical conductivity with fewer pinholes in a gold coating, a method of producing the electroconductive fine particles, which are cyan-free type with a plating bath excellent in stability, and an anisotropic electroconductive material using the electroconductive fine particles.

### MEANS FOR SOLVING THE OBJECT

To achieve the object described above, the invention described in Claim 1 provides electroconductive fine particles, which have a gold coating formed by electroless gold plating on the surface of a nickel undercoating, the amount of nickel dissolved in a dissolution test of the electroconductive fine particles with nitric acid being 30 to 100 µg/g.

The invention described in Claim 2 provides a method of producing the electroconductive fine particle according to Claim 1, wherein the method allows a reducing agent, causing oxidation reaction on the surface of a nickel undercoating but not causing oxidation reaction on the surface of gold as deposited metal, to be present on the surface of the nickel undercoating thereby reduces a gold salt to deposit gold.

The invention described in claim 3 provides an anisotropic electroconductive material, which comprises the electroconductive fine particle according to Claim 1 dispersed in a resin binder.

Hereinafter, the present invention will be described in detail.
The electroconductive fine particles of the present invention are electroconductive fine particles, which have a gold coating formed by electroless gold plating on the surface of a nickel undercoating.

The electroconductive fine particles of the present invention have a nickel coating, and can be obtained by forming a nickel coating on the surfaces of core particles.
The material of the core particles may be an organic type or inorganic type material and is not particularly limited insofar as it has suitable elastic modulus, elastic deformation, and restoration, but the material is preferably an organic type material such as resin particles.
The organic type material is not particularly limited, and examples thereof include phenol resin, amino resin, polyester resin, urea resin, melamine resin, epoxy resin and a divinyl benzene polymer; divinyl benzene type polymers such as a divinyl benzene-styrene copolymer, a divinyl benzene-(meth)acrylate ester copolymer etc.; and a (meth)acrylate ester polymer. The (meth)acrylate ester polymer used may be a crosslinked polymer or non-crosslinked polymer, or a mixture of the two, depending on the necessity. In particular, the divinyl benzene type polymer or (meth)acrylate ester type polymer is preferably used. As used herein, "(meth)acrylate ester" means methacrylate ester or acrylate ester.
The inorganic type material includes, for example, metal, glass, ceramics, metal oxides, metal silicates, metal carbides, metal nitrides, metal carbonates, metal sulfates, metal phosphates, metal sulfides, metal acid salts, metal halides, carbon etc.
These core materials may be used alone or as a mixture of two or more thereof.

The method of forming a nickel coating on the surface of a core particle is not particularly limited, and mention is made of methods such as, for example, electroless plating, electroplating, hot-dip plating, and vapor deposition. When the core particles are non-electroconductive particles such as resin particles, the method of forming a coating by electroless plating is preferably used.

The shape of the particles having a nickel coating formed on the surfaces of core particles is not particularly limited insofar as the particles can be suspended in water by usual dispersion techniques, and for example, the particles may be those in a specific form, for example a spherical, fibrous, hollow or needle form or in an amorphous form. Particularly it is preferable for the particles having a nickel coating on the surfaces of core particles in order to achieve excellent electrical connection to be spherical.

The particle diameter of the particle having a nickel coating formed on the surface of a core particle is not particularly limited, but is preferably 1 to 100 µm, more preferably 2 to 20 µm.

The electroconductive fine particles of the present invention have a gold coating formed by electroless gold plating on the surface of a nickel coating as an undercoating, wherein the amount of nickel dissolved in a dissolution test of the electroconductive fine particles with nitric acid should be 30 to 100 µg/g.

When the amount of dissolved nickel in the dissolution test of the electroconductive fine particles of the present invention with nitric acid is 30 to 100 µg/g, the resulting electroconductive fine particles are almost free of pinholes in a gold coating formed by electroless gold plating, attributable to dissolution of the nickel undercoating. Accordingly, the resulting electroconductive fine particles have excellent electrical conductivity because of fewer pinholes in the gold coating.

In the present invention, the dissolution test using nitric acid can be carried out by the way where the amount of nickel dissolved by dipping for 15 minutes in 1 wt% nitric acid solution is measured by neutralization titration. Specifically, for example, the way is where 1 g sample is dipped in 1 wt% nitric acid solution and the amount of dissolved nickel is examined by neutralization titration.

The method of forming a gold coating by electroless gold plating on the surface of the nickel coating is not particularly limited insofar as it is a method wherein the amount of nickel dissolved becomes 30 to 100 µg/g, but a method of substrate-catalyzed reduction-type electroless gold plating for example is preferably used because pinholes in a gold coating can be reduced. And the method of substrate-catalyzed reduction-type electroless gold plating may be used in combination with for example a method of autocatalytic reduction-type electroless gold plating and/or a method of substitution-type electroless gold plating.

The method of substrate-catalyzed reduction-type electroless gold plating described above is a method of forming a gold coating wherein a reducing agent causing oxidation reaction on the surface of a nickel undercoating but not causing oxidation reaction on the surface of gold as deposited metal is allowed to be present on the surface of the nickel undercoating thereby reducing a gold salt to deposit gold.

According to the substrate-catalyzed reduction-type electroless gold plating described above, unlike the substitution-type electroless gold plating, the plating bath is not contaminated with dissolved undercoating nickel ions, and unlike the autocatalytic reduction-type electroless gold plating, the plating bath is excellent in stability without decomposing and depositing gold in the plating bath.

The gold salt is not particularly limited, and for example, gold cyanides such as KAu(CN)₂, sodium chloroaurates such as NaAuCl₄·2H₂O, gold halides such as chloroauric acid, and cyan-free type gold salts such as gold sulfite.
By using the cyan-free type gold salts, cyan-free type electroless gold plating can be carried out, and since a strong alkali such as in a cyan bath is not used, cyan-free type electroless gold plating does not cause corrosion of core particles etc. and is not harmful to the environment. Among the cyan-free type gold salts, chloroaurates such as sodium chloroaurate and chloroauric acid are preferable because an excellent gold plating can be formed.

It follows that in the method of producing the electroconductive fine particles of the present invention, it is preferable that a reducing agent causing oxidation reaction on the surface of a nickel undercoating but not causing oxidation reaction on the surface of gold as deposited metal is allowed to be present on the surface of the nickel undercoating thereby reducing sodium chloroaurate to deposit gold.
The method of producing the electroconductive fine particles as described above also constitutes one aspect of the present invention.

Now, the method of substrate-catalyzed reduction-type electroless gold plating is specifically described.
The method of substrate-catalyzed reduction-type electroless gold plating described above is a method of depositing a gold coating by using, as a catalyst, nickel in the nickel coating as the undercoating.
Because this gold plating method makes use of the undercoating as a catalyst, a site plated once with gold is no more plated with gold, so electroconductive fine particles having a gold coating of very even and constant thickness can be obtained.

As the undercoating, the nickel coating includes, for example, not only a pure nickel metallic coating but also a nickel-phosphorus alloy coating, a nickel-boron alloy coating, etc.
The content of phosphorus in the nickel-phosphorus alloy coating is not particularly limited, but is preferably 0.5 to 15 wt%.
The content of boron in the nickel-boron alloy coating is not particularly limited, but is preferably 0.5 to 3 wt%.

The substrate-catalyzed reduction-type electroless gold plating bath is for example a plating bath based on chloroaurate containing thiosulfate salt as a complexing agent, sulfite salt as a reducing agent, and ammonium hydrogen phosphate as a buffer agent, and so on. The plating bath further containing hydroxylamine is more preferably used because more uniform deposition of gold is feasible.
Among the thiosulfate salt, thiosulfate ammonium is preferable. And among the sulfite salt, ammonium sulfite is preferable.

The concentration of chloroaurate in the plating bath is preferably 0.01 to 0.1 mol/L, more preferably 0.01 to 0.03 mol/L.
The concentration of thiosulfate salt as the complexing agent in the plating bath is preferably 0.08 to 0.8 mol/L, more preferably 0.08 to 0.24 mol/L.
The concentration of sulfite salt as the reducing agent in the plating bath is preferably 0.3 to 2.4 mol/L, more preferably 0.3 to 1 mol/L.
The concentration of hydroxylamine for stabilizing gold deposition in the plating bath is preferably 0.1 to 0.3 mol/L, more preferably 0.1 to 0.15 mol/L.

As a pH adjusting agent for regulating pH in the plating bath, for example sodium hydroxide, ammonia etc. are mentioned for adjustment to the alkaline side, among which sodium hydroxide is preferable, and sulfuric acid, hydrochloric acid etc. are mentioned for adjustment to the acid side, among which sulfuric acid is preferable.
The pH of the plating bath is preferably higher within the range of 8 to 10 in order to increase the driving force of the reaction.

The bath temperature of the plating bath is preferably higher for increasing the driving force of the reaction, but because bath degradation may be caused at a too high bath temperature, the bath temperature is preferably 50 to 70°C.

Unless the particles in the plating bath are uniformly dispersed in the aqueous solution, aggregation by the reaction occurs easily, so preferably aggregation is prevented by uniformly dispersing the particles by sonication and/or with a stirrer.

More preferably, aggregation is prevented not only by the physical method described above but also chemically by using a surfactant such as polyethylene glycol in combination with the physical method.

The anisotropic electroconductive material of the present invention comprises the electroconductive fine particles of the present invention dispersed in a resin binder.

The anisotropic electroconductive material is not particularly limited insofar as the electroconductive fine particles of the present invention have been dispersed in a resin binder, and examples thereof include an anisotropic electroconductive paste, an anisotropic electroconductive ink, an anisotropic electroconductive pressure-sensitive adhesive, an anisotropic electroconductive film and an anisotropic electroconductive sheet and so on.

The method of producing the anisotropic electroconductive material of the present invention is not particularly limited, and the method includes, for example, a method wherein the electroconductive fine particles of the present invention are added to, and mixed uniformly with, an insulating resin binder to form, for example, an anisotropic electroconductive paste, an anisotropic electroconductive ink, an anisotropic electroconductive pressure-sensitive adhesive or the like, and a method wherein the electroconductive fine particles of the present invention are added to, and mixed to be dispersed uniformly with, an insulating resin binder to form an electroconductive composition, and then the electroconductive composition is dissolved (dispersed) uniformly in an organic solvent or melted under heating if necessary, and applied to form a film of predetermined thickness on the release-treated surface of a release material such as release paper or release film, which may be followed by drying, cooling etc. if necessary, to form, for example, an anisotropic electroconductive film, an anisotropic electroconductive sheet or the like, and the production method may be suitably selected depending on the type of the anisotropic electroconductive material to be prepared. To produce the anisotropic electroconductive material, the insulating resin binder and the electroconductive fine particles of the present invention may be used separately without being mixed.

As the resin of the insulating resin binder, the resin is not particularly limited, and examples thereof include vinyl type resin such as vinyl acetate type resin, vinyl chloride type resin, acrylic type resin, styrene type resin etc.; thermoplastic resin such as polyolefin type resin, an ethylene-vinyl acetate copolymer, polyamide type resin etc.; curable resins comprising epoxy type resin, urethane type resin, polyimide type resin, and unsaturated polyester type resin, and their indurative agent; thermoplastic block copolymers such as a styrene-butadienestyrene block copolymer, a styrene-isoprene-styrene block copolymer and hydrogenated products of the above; and elastomers (rubber) such as styrene-butadiene copolymer rubber, chloroprene rubber, and acrylonitrile-styrene block copolymer rubber. These resins may be used alone or as a mixture of two or more thereof. The curable resins may be any curable type such as cold-setting type, thermosetting type, photosetting type, humidity setting type, etc.

In addition to the insulting resin binder and the electroconductive fine particles of the present invention, one or more kinds of additives such as a filler, a softener (plasticizer), an adhesion improver, an antioxidant (aging inhibitor), a heat stabilizer, a light stabilizer, a UV absorber, a colorant, a flame-retardant and an organic solvent may be simultaneously used if necessary in the anisotropic electroconductive material of the present invention in such a range as not to inhibit achievement of the object of the present invention.

### EFFECT OF THE INVENTION

Because the electroconductive fine particles of the present invention are constituted as described above, the electroconductive fine particles having excellent electrical conductivity with fewer pinholes in a gold coating can be obtained. By the method of producing electroconductive fine particles according to the present invention, electroconductive fine particles having excellent electrical conductivity with less pinholes in a gold coating can be obtained in a cyan-free system with a plating bath excellent in stability. Further, an anisotropic electroconductive material using the electroconductive fine particles of the present invention has excellent electrical conductivity.

### BEST MODE FOR CARRYING OUT THE INVENTION

Hereinafter, the present invention will be described in details with reference to examples, however the present invention is not limited to these examples.

### (Example 1)

Divinyl benzene type polymer resin particles having a particle diameter of 4 µm (manufactured by Sekisui Chemical Co., Ltd.) were treated for 5 minutes with 10 wt% ion adsorbent, then treated for 5 minutes with 0.01 wt% aqueous palladium sulfate, further subjected to reduction treatment by adding dimethyl amine borane, filtered, washed, and reacted by dipping in a nickel plating solution to obtain fine particles plated with nickel.

Then, a solution containing 10 g of sodium chloroaurate and 1000 mL of deionized water was prepared, and 10 g of the resulting fine particles plated with nickel was mixed with the solution to prepare an aqueous suspension.
30 g of ammonium thiosulfate, 80 g of ammonium sulfite and 40 g of ammonium hydrogen phosphate were introduced into the resulting aqueous suspension to prepare a plating solution.
10 g of hydroxyl amine was introduced into the resulting plating solution which was then adjusted to pH 10 with ammonia, and the mixture was reacted for about 15 to 20 minutes at a bath temperature of 60°C, whereby electroconductive fine particles having a gold coating formed thereon were obtained.

The resulting electroconductive fine particles were dipped for 15 minutes in 1 wt% nitric acid solution, and the amount of dissolved nickel was measured by neutralization titration. As a result of this dissolution test using nitric acid, the amount of dissolved nickel was 52 µg/g.

### (Example 2)

For the nickel-plated fine particles obtained in Example 1, a solution containing 16 g of chloroauric acid and 1000 mL of deionized water was prepared and then mixed with 10 g of the nickel-plated fine particles to prepare an aqueous suspension.
30 g of ammonium thiosulfate, 80 g of ammonium sulfite, and 40 g of ammonium hydrogen phosphate were introduced into the resulting aqueous suspension to prepare a plating solution. 5 g of aminopyridine was introduced into the resulting plating solution which was then adjusted to pH 7 with ammonia, and the mixture was reacted for about 15 to 20 minutes at a bath temperature kept at 60°C, whereby electroconductive fine particles having a gold coating formed thereon was obtained.

The resulting electroconductive fine particles were dipped for 15 minutes in 1 wt% nitric acid solution, and the amount of dissolved nickel was measured by neutralization titration. As a result of this dissolution test using nitric acid, the amount of dissolved nickel was 52 µg/g.

### (Comparative Example 1)

Fine particles plated with nickel were obtained in the same manner as in Example 1.
Then, a solution containing 7 g of potassium gold cyanide and 1000 mL of deionized water was prepared, and 10 g of the resulting fine particles plated with nickel were mixed with the solution to prepare an aqueous suspension.
30 g of EDTA·4Na and 20 g of citric acid monohydrate were introduced into the resulting aqueous suspension to prepare a plating solution.
The resulting plating solution was adjusted to pH 5.5 with ammonia, and the mixture was reacted for about 20 to 30 minutes at a bath temperature of 70°C, whereby electroconductive fine particles having a gold coating formed thereon by substitution gold plating were obtained.

The resulting electroconductive fine particles were examined in the same dissolution test with nitric acid as in Example 1. As a result, the amount of dissolved nickel was 213 µg/g.

### (Example 3)

The electroconductive fine particles obtained in Example 1 were added to 100 parts of epoxy resin (Epicoat 828, manufactured by Yuka-Shell Epoxy Co., Ltd.) as resin of the resin binder, 2 parts of tris-dimethylaminoethyl phenol and 100 parts of toluene, then sufficiently mixed by a sun-and-planet stirrer, and applied onto a release film such that the resulting coating after drying became 7 µm, and then the toluene was evaporated, whereby an adhesive film containing the electroconductive fine particles was obtained. The amount of the electroconductive fine particles incorporated into the film was 50,000 particles/cm².
Thereafter, the adhesive film containing the electroconductive fine particles was stuck at ordinary temperatures onto an adhesive film obtained without incorporating the electroconductive fine particles, to obtain an anisotropic electroconductive film of 2-layer structure having a thickness of 17 µm.

### (Comparative Example 2)

An anisotropic electroconductive film was obtained in the same manner as in Example 3 except that the electroconductive fine particles obtained in Comparative Example 1 were added.

### (Evaluation of the electrical conductivity of the anisotropic electroconductive material)

The obtained anisotropic electroconductive film was cut in a size of 5×5 mm. Separately, two glass substrates each having an aluminum electrode with a width of 200 µm, a length of 1 mm, a height of 0.2 µm, and L/S 20 µm, one of which had a leading wire for measurement of resistance, were prepared. The anisotropic electroconductive film was stuck onto almost the center of one glass substrate, and the other glass substrate was stuck onto the glass substrate on which the anisotropic electroconductive film had been stuck, so as to allow their electrode patterns to be laid on each other.
The two glass substrates were thermally contact-bonded under the conditions of a pressure of 10 N and a temperature of 180°C, and the resistance between the electrodes was measured. The anisotropic electroconductive films obtained in Example 3 and Comparative Example 2 were measured respectively.
The prepared test specimen was examined in a PCT test (the specimen was kept for 1000 hours under a high-temperature and high-humidity environment at 80°C and 95% RH) and then the resistance between the electrodes was measured.
The evaluation results are shown in Table 1.

**Table 1**

| | Resistance between the electrodes (Ω) (under ordinary conditions) | Resistance between the electrodes (Ω) (after the PCT test) (after 1000 hours at 80°C. 95%RH) | Evaluation |
|---|---|---|---|
| Example3 | 2. 7 | 6. 2 | ○ |
| Comparative Example2 | 12.3 | 32. 1 | × |

Table 1 shows that the anisotropic electroconductive film in Example 3 using the electroconductive fine particles obtained in Example 1 has lower connection resistance than that of the anisotropic electroconductive film in Comparative Example 2 using the electroconductive fine particles obtained in Comparative Example 1. In addition, the degree of the increase in resistance after the PCT test is lower in Example 3 than in Comparative Example 2. The cause of the lower resistance is considered attributable to fewer pinholes in the gold plating.

### Industrial Applicability

According to the present invention, there can be provided electroconductive fine particles having excellent electrical conductivity with fewer pinholes in a gold coating, a method of producing the electroconductive fine particles, which are cyan-free type with a plating bath excellent in stability, and an anisotropic electroconductive material using the electroconductive fine particles.

## Claims

1. An electroconductive fine particle,
which has a gold coating formed by electroless gold plating on the surface of a nickel undercoating,
the amount of nickel dissolved in a dissolution test of the electroconductive fine particle with nitric acid being 30 to 100 µg/g.

2. A method of producing the electroconductive fine particle according to Claim 1,
wherein the method allows a reducing agent, causing oxidation reaction on the surface of a nickel undercoating but not causing oxidation reaction on the surface of gold as deposited metal, to be present on the surface of the nickel undercoating thereby reduces a gold salt to deposit gold.

3. An anisotropic electroconductive material,
which comprises the electroconductive fine particle according to Claim 1 dispersed in a resin binder.
